(19) Europäisches Patentamt

European Patent Office

Office européen des brevets

(11) **EP 4 589 847 A1**

(12) **EUROPEAN PATENT APPLICATION**

published in accordance with Art. 153(4) EPC

(43) Date of publication:
   **23.07.2025 Bulletin 2025/30**

(21) Application number: **23920176.7**

(22) Date of filing: **29.12.2023**

(51) International Patent Classification (IPC):
   **H03K 17/06** (2006.01)    **H03K 17/687** (2006.01)
   **H02H 7/18** (2006.01)

(52) Cooperative Patent Classification (CPC):
   **H02H 7/18; H03K 17/06; H03K 17/687**

(86) International application number:
   **PCT/KR2023/021962**

(87) International publication number:
   **WO 2024/162627 (08.08.2024 Gazette 2024/32)**

(84) Designated Contracting States:
   **AL AT BE BG CH CY CZ DE DK EE ES FI FR GB
   GR HR HU IE IS IT LI LT LU LV MC ME MK MT NL
   NO PL PT RO RS SE SI SK SM TR**
   Designated Extension States:
   **BA**
   Designated Validation States:
   **KH MA MD TN**

(30) Priority: **30.01.2023 KR 20230012149
                02.03.2023 KR 20230027783**

(71) Applicant: **Samsung Electronics Co., Ltd.
   Suwon-si, Gyeonggi-do 16677 (KR)**

(72) Inventors:
• **JANG, Jinyoung**
   **Suwon-si Gyeonggi-do 16677 (KR)**
• **KWON, Taeyoun**
   **Suwon-si Gyeonggi-do 16677 (KR)**
• **KIM, Yongwoon**
   **Suwon-si Gyeonggi-do 16677 (KR)**
• **PARK, Eunsoo**
   **Suwon-si Gyeonggi-do 16677 (KR)**
• **AN, Jinwan**
   **Suwon-si Gyeonggi-do 16677 (KR)**

(74) Representative: **Nederlandsch Octrooibureau
   P.O. Box 29720
   2502 LS The Hague (NL)**

(54) **SWITCH CIRCUIT FOR REDUCING LEAKAGE CURRENT, AND ELECTRONIC DEVICE USING SAME**

(57)    A switch circuit for reducing leakage current, and an electronic device using same are disclosed. The switch circuit comprises a first resistance, a first transistor and a second transistor, wherein a first end of the first resistance is connected to an operating power source for operating the switch circuit, a second end of the first resistance is connected to a drain terminal of the first transistor and a gate terminal of the second transistor, a gate terminal of the first transistor is connected to a ground end, a source terminal of the first transistor is connected to a battery sensing end of a battery and a source terminal of the second transistor, and a drain terminal of the second transistor is connected to a device sensing end.

**FIG. 3**

EP 4 589 847 A1

## Description

## TECHNICAL FIELD

The following embodiments relate to a switch circuit for reducing leakage current and an electronic device using the same.

## BACKGROUND ART

As various electronic devices are increasingly used in various environments and situations, research is actively being conducted to efficiently manage the batteries of electronic devices. In particular, various methods are required to control leakage current that occurs after a battery is assembled into an electronic device.

## DISCLOSURE OF THE INVENTION

## TECHNICAL GOALS

A switch circuit for reducing leakage current according to an embodiment may include a first resistance. The switch circuit may further include a first transistor. The switch circuit may further include a second transistor. A first end of the first resistance may be connected to an operating power for operating the switch circuit, a second end of the first resistance may be connected to a drain terminal of the first transistor and a gate terminal of the second transistor, a gate terminal of the first transistor may be connected to a ground terminal, a source terminal of the first transistor may be connected to a battery sensing end of a battery and a source terminal of the second transistor, and a drain terminal of the second transistor may be connected to a device sensing end.

A switch circuit for reducing leakage current according to an embodiment may include a first resistance. The switch circuit may further include a second resistance. The switch circuit may further include a first transistor. The switch circuit may further include a second transistor. A first end of the first resistance may be connected to an operating power for operating the switch circuit, a second end of the first resistance may be connected to a first end of the second resistance and a gate terminal of the second transistor, a second end of the second resistance may be connected to a drain terminal of the first transistor, a gate terminal of the first transistor may be connected to a ground terminal, a source terminal of the first transistor may be connected to a battery sensing end and a source terminal of the second transistor, and a drain terminal of the second transistor may be connected to a device sensing end.

An electronic device using a switch circuit for reducing leakage current according to an embodiment may include a battery including a battery cell and a protection circuit configured to protect the battery cell from over-discharge. The electronic device may further include a power management module including a voltage sensing unit configured to sense a voltage of the battery by being directly connected to the battery cell without going through the protection circuit and a switch circuit configured to block a path between the battery and the voltage sensing unit in response to the protection circuit being deactivated.

## BRIEF Description of Drawings

FIG. 1 is a block diagram of an electronic device including a switch circuit for reducing leakage current according to an embodiment.
FIG. 2 is a diagram illustrating the flow of current in a battery cell voltage sensing circuit according to a comparative example.
FIG. 3 is a diagram illustrating a configuration of an electronic device including a switch circuit for reducing leakage current according to an embodiment.
FIGS. 4A and 4B are diagrams illustrating an operation of a switch circuit for reducing leakage current according to an embodiment.
FIG. 5 is a diagram illustrating an operating power of a switch circuit for reducing leakage current according to an embodiment.

## Best Mode for Carrying Out the Invention

Battery cell sensing, which is a scheme of sensing a voltage of a battery in an electronic device, has the advantage of being able to accurately measure the voltage of a battery. However, even when a battery protection circuit is disabled, there may be an issue of leakage current occurring through unintended battery discharge paths, causing battery swelling and battery performance degradation.

A switch circuit for reducing leakage current according to an embodiment of the present disclosure and an electronic device using the same may minimize leakage current and improve battery stability of the electronic device through the switch circuit that controls a discharge path according to various scenarios.

Hereinafter, embodiments will be described in detail with reference to the accompanying drawings. When describing the embodiments with reference to the accompanying drawings, like reference numerals refer to like elements and any repeated description related thereto will be omitted.

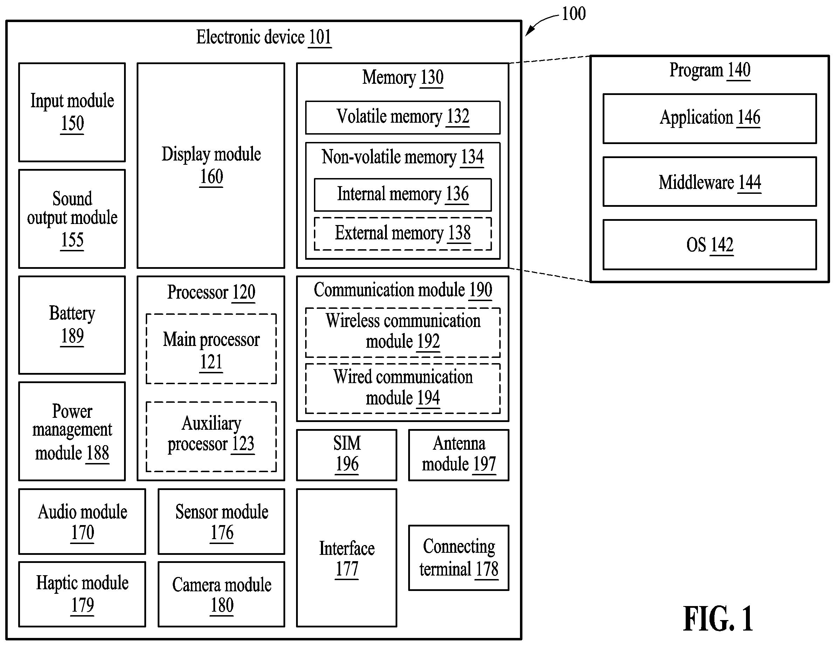

FIG. 1 is a block diagram of an electronic device including a switch circuit for reducing leakage current according to an embodiment.

Referring to FIG. 1, an electronic device 101 in a network environment 100 may communicate with an electronic device 102 via a first network 198 (e.g., a short-range wireless communication network), or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be integrated as a single component (e.g., the display module 160).

The processor 120 may execute, for example, software (e.g., a program 140) to control at least one other component (e.g., a hardware or software component) of the electronic device 101 connected to the processor 120 and may perform various data processing or computation. According to an embodiment, as at least part of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)) or an auxiliary processor 123 (e.g., a graphics processing unit (GPU), a neural processing unit (NPU), an image signal processor (ISP), a sensor hub processor, or a communication processor (CP)) that is operable independently of, or in conjunction with the main processor 121. For example, when the electronic device 101 includes the main processor 121 and the auxiliary processor 123, the auxiliary processor 123 may be adapted to consume less power than the main processor 121 or to be specific to a specified function. The auxiliary processor 123 may be implemented separately from the main processor 121 or as a part of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence model processing. An artificial intelligence model may be generated through machine learning. Such learning may be performed, for example, by the electronic device 101 in which an artificial intelligence model is executed, or via a separate server (e.g., the server 108). Learning algorithms may include, but are not limited to, for example, supervised learning, unsupervised learning, semi-supervised learning, or reinforcement learning. The artificial intelligence model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The artificial intelligence model may additionally or alternatively include a software structure other than the hardware structure.

The memory 130 may store various pieces of data used by at least one component (e.g., the processor 120 or the sensor module 176) of the electronic device 101. The various pieces of data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a record. The receiver may be used to receive an incoming call. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, the hologram device, and the projector. According to an embodiment, the display module 160 may include a touch sensor adapted to sense a touch, or a pressure sensor adapted to measure the intensity of force incurred by the touch.

The audio module 170 may convert a sound into an electrical signal or vice versa. According to an embodiment, the audio module 170 may obtain the sound via the input module 150 or output the sound via the sound output module 155 or an external electronic device (e.g., the electronic device 102 such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101, and generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or an electrical stimulus which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC). The power management module 188 may include a voltage sensing unit that is directly connected to a battery cell to sense a voltage of the battery without going through a protection circuit that protects the battery cell from over-discharge, and a switch circuit that blocks a path between the battery and the voltage sensing unit when the protection circuit is disabled.

The battery 189 may supply power to at least one component of the electronic device 101. According to an embodiment, the battery 189 may include, for example, a primary cell which is not rechargeable, a secondary cell which is rechargeable, or a fuel cell. The battery 189 may include, for example, battery cells and a protection circuit that protects the battery cells from over-discharge.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently of the processor 120 (e.g., an AP) and that support a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a fifth generation (5G) network, a next-generation communication network, the Internet, or a computer network (e.g., a LAN or a wide area network (WAN))). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a fourth generation (4G) network, and a next-generation communication technology, e.g., a new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., a mmWave band) to achieve, e.g., a high data transmission rate. The wireless communication module 192 may support various technologies for securing performance on a high-frequency band, such as, e.g., beamforming, massive multiple-input and multiple-output (MIMO), full dimensional MIMO (FD-MIMO), an array antenna, analog beam-forming, or a large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or power may be transmitted or received between the communication module 190 and the external electronic device via the at least one selected antenna. According to an embodiment, another component (e.g., a radio frequency integrated circuit (RFIC)) other than the radiating element may be additionally formed as a part of the antenna module 197.

According to embodiments, the antenna module 197 may form a mmWave antenna module. According to an example embodiment, the mmWave antenna module may include a PCB, an RFIC disposed on a first surface (e.g., a bottom surface) of the PCB or adjacent to the first surface and capable of supporting a designated a high-frequency band (e.g., the mmWave band), and a plurality of antennas (e.g., array antennas) disposed on a second surface (e.g., a top or a side surface) of the PCB, or adjacent to the second surface and capable of transmitting or receiving signals in the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of the same type as or a different type from the electronic device 101. According to an example embodiment, all or some of operations to be executed by the electronic device 101 may be executed at one or more external electronic devices (e.g., the external devices 102 and 104, or the server 108). For example, if the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer an outcome of the performing to the electronic device 101. The electronic device 101 may provide the outcome, with or without further processing of the outcome, as at least part of a reply to the request. To this end, cloud computing, distributed computing, mobile edge computing (MEC), or client-server computing technology may be used, for example. The electronic device 101 may provide ultra low-latency services using, e.g., distributed computing or MEC. In an embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

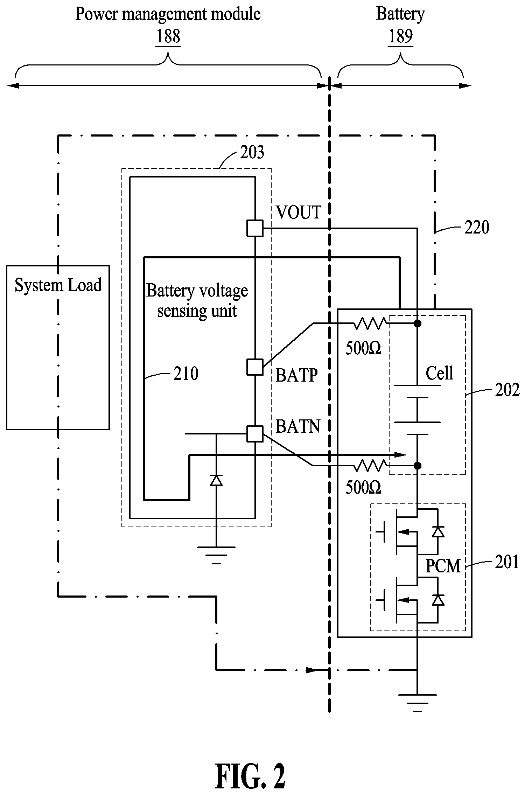

FIG. 2 is a diagram illustrating the flow of current in a battery cell voltage sensing circuit according to a comparative example.

Referring to FIG. 2, a current discharge path of the battery cell voltage sensing circuit is shown. The battery cell voltage sensing scheme may sense a voltage of the battery 189 more accurately through a battery voltage sensing unit 203 by directly connecting a cell sensing line 210 to a battery cell 202 without going through a protection circuit module (PCM) 201 of the battery.

The battery cell voltage sensing scheme has the advantage of being able to sense the exact voltage of the battery 189, but has the problem of causing continuous battery leakage current in the battery voltage sensing unit 203 through a path such as the cell sensing line 210 even when the PCM 201 of the battery 189 operates below a specific low voltage to prevent over-discharge of the battery 189. When the battery 189 is discharged below a low voltage, a side reaction of the battery cell 202 may occur, which may result in battery swelling and a significant degradation in characteristics. To prevent this, the PCM 201 disconnects a battery power line 220 at a specific low voltage level to secure a discharge period down to the low voltage of the battery 189. However, in the battery cell voltage sensing scheme, even when the PCM 201 of the battery operates, the cell sensing line 210 is connected, and a continuous leakage current occurs in the battery voltage sensing unit 203, which has the problem of reducing the battery performance maintenance period. For example, due to the nature of the scheme of performing battery sensing directly with the battery cell 202 inside the battery 189, the cell sensing line 210 is formed through a ground terminal of the battery cell 202 of a sensing integrated circuit (IC), which may cause a leakage current of a certain level (e.g., 30 uA). Leakage current may cause the battery to reach a low battery voltage in a shorter time, which may cause problems such as battery swelling and degradation of battery characteristics and reduce the usable shelf life of the battery.

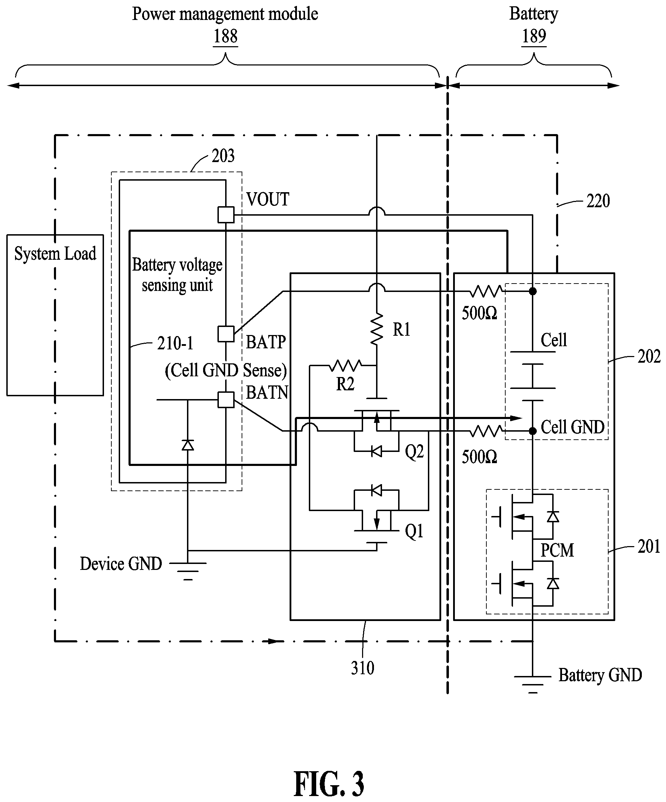

FIG. 3 is a diagram illustrating a configuration of an electronic device including a switch circuit for reducing leakage current, according to an embodiment.

Referring to FIG. 3, the electronic device may significantly increase a low voltage discharge period of the battery 189 by about 7.5 times, for example, from about 1.74 months to about 13 months, through a switch circuit 310 that controls a leakage path of a cell sensing line 210-1 by the voltage sensing structure of the battery cell 202. The switch circuit 310 may control a connection of the cell sensing line 210-1 formed through the battery voltage sensing unit 203. Through this, for example, a transistor (e.g., a field effect transistor (FET)) included in the PCM 201 may operate as a switch to short-circuit the cell sensing line 210-1 even in an open state of the PCM 201 in which the PCM 201 is turned off. By short-circuiting the cell sensing line 210-1, the battery discharge period may be improved compared to before, thereby increasing the standby period after battery shipment. Short-circuiting the cell sensing line 210-1 may also solve battery swelling issues that may occur when the battery is left unattended for a long time, and ensure terminal stability of the electronic device.

Charging the battery may be divided into two schemes, pre-charging without identifying the battery voltage and charging after sensing the battery voltage, which is done after identifying the battery voltage. The charging scheme after sensing the battery voltage may be changed according to an energy policy of a country using the electronic device, and the switch circuit 310 may operate to reduce leakage current regardless of which of the two schemes is used for charging.

The path 220 may be an actual intended discharge path of the power management module 188 when the battery is discharged. The cell sensing line 210 may be an unintended discharge path of the battery cell 202 after the PCM 201 of the battery 189 is opened at a battery voltage corresponding to a threshold value. In a battery voltage range below a threshold value, the transistor (e.g., an FET) included in the PCM 201 inside the battery 189 may be turned off, and the path 220 indicating a discharge path of the power management module 188 may be cut off, thereby reducing current consumption and extending the usable shelf life of the battery.

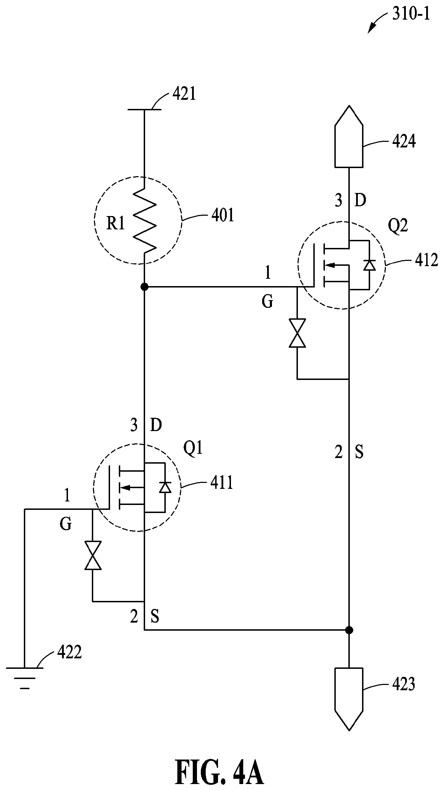

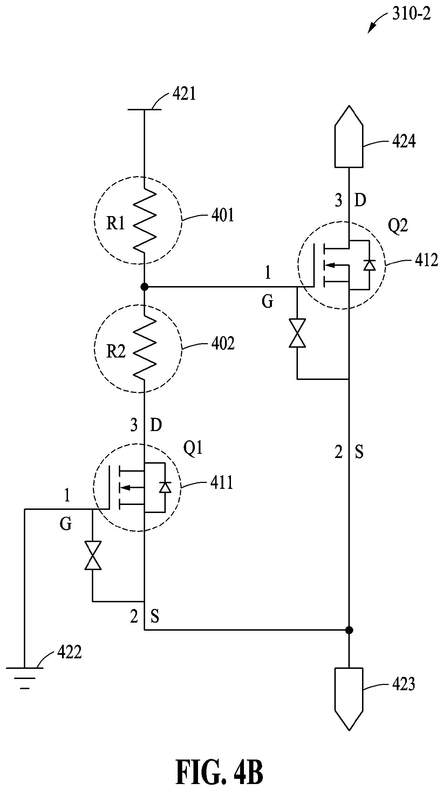

FIGS. 4A and 4B are diagrams illustrating an operation of a switch circuit for reducing leakage current according to an embodiment. Hereinafter, an operation of the switch circuit with respect to each of the two battery charging schemes described above, pre-charging without identifying the battery voltage and charging after sensing the battery voltage, which is done after identifying the battery voltage, is described. In an embodiment, a voltage of an operating power for operating the switch circuit may have a voltage value within a predefined range while satisfying the electrical characteristics of each element of the switch circuit.

Referring to FIG. 4A, in the switch circuit according to an embodiment, a pre-charging operation may be performed without identifying the battery voltage when a charger is inserted. The switch circuit may correspond to a circuit driven in a scenario where a protection circuit of the battery is immediately turned on after the charger is inserted, and the power circuit of the electronic device and the battery are formed into a closed loop from the moment of the insertion of the charger.

A switch circuit 310-1 may include a first resistance 401, a first transistor 411, and a second transistor 412. In an embodiment, the first transistor 411 and the second transistor 412 may be NMOS transistors. The second transistor 412 may perform a function of maintaining a voltage of a gate terminal of the second transistor 412 within a predefined range via the first resistance 401. The second transistor 412 may maintain the voltage of the gate terminal by using, for example, the first resistance 401 as a pull-up resistance. A first end of the first resistance 401 may be connected to an operating power 421 that operates the switch circuit. A second end of the first resistance 401 may be connected to a drain terminal of the first transistor 411 and the gate terminal of the second transistor 412. A gate terminal of the first transistor 411 may be connected to a ground terminal 422. A source terminal of the first transistor 411 may be connected to a battery sensing end 423 of the battery 189 and a source terminal of the second transistor 412. The first transistor 411 may be connected to the source terminal of the second transistor 412 via the source terminal and may perform an operation of accurately determining an input state of the second transistor 412. A drain terminal of the second transistor 412 may be connected to a device sensing end 424. The second transistor 412 may perform an operation of connecting or disconnecting a path between the device sensing end 424 of the battery 189 and the battery sensing end 423 of the battery 189, which may vary depending on a state of a low dropout power, for example, a linear regulator that operates even at low input/output electric potential differences.

In an embodiment, when the power of the battery 189 is turned on, the second transistor 412 may perform an operation of connecting a path between the device sensing end 424 and the battery sensing end 423. In an embodiment, the second transistor 412 may be turned on, for example, when the low dropout power is turned on, to perform an operation of connecting a sensing line between the device sensing end 424 and the battery sensing end 423.

In an embodiment, when the power of the battery 189 is turned off, the second transistor 412 may perform an operation of disconnecting the path between the device sensing end 424 and the battery sensing end 423. In an embodiment, the second transistor 412 may be turned off, for example, when the low dropout power is turned off, to perform the operation of disconnecting the sensing line between the device sensing end 424 and the battery sensing end 423.

In an embodiment, when the battery 189 is being charged, the second transistor 412 may perform the operation of connecting the path between the device sensing end 424 and the battery sensing end 423. In an embodiment, the second transistor 412 may be turned on to connect the sensing line between the device sensing end 424 and the battery sensing end 423 as in a case where the low dropout power is turned on when there is an input from the charger, for example in a low voltage situation where the low dropout power may not be controlled. In this pre-charging scheme, leakage current may be reduced by controlling the connection and disconnection of the sensing line via the switch circuit 310-1.

Referring to FIG. 4B, in the switch circuit according to an embodiment, when a charger is inserted, unlike as described with reference to FIG. 4A, there may be a case where charging is started after sensing the battery voltage to maximize power management policy and battery stability in a specific business operator. In an embodiment, a switch circuit 310-2 may use, for example, a power source voltage of the electronic device or the operating power 421 that operates the switch circuit as a gate terminal voltage of the second transistor 412.

The switch circuit 310-2 may include the first resistance 401, a second resistance 402, the first transistor 411, and the second transistor 412. In an embodiment, the first transistor 411 and the second transistor 412 may be NMOS transistors. In some cases, the second resistance 402 may have a resistance value below a predefined range, for example, a resistance value close to zero, and may operate in the same manner as the switch circuit 310-1 described with reference to FIG. 4A. In an embodiment, the switch circuit 310-2 may correspond to a switch circuit that further includes the second resistance 402, and in which the first end of the second resistance 402 is connected to the second end of the first resistance 401 and the second end of the second resistance 402 is connected to the drain terminal of the first transistor 411, compared to the switch circuit 310-1 described with reference to FIG. 4A.

The first end of the first resistance 401 may be connected to the operating power 421 that operates the switch circuit 310-2. The second end of the first resistance 401 may be connected to the first end of the second resistance 402 and the gate terminal of the second transistor 412. The second end of the second resistance 402 may be connected to the drain terminal of the first transistor 411. The second transistor 412 may perform an operation of maintaining a voltage of the gate terminal of the second transistor 412 within a predefined range via the first resistance 401 and the second resistance 402. A gate terminal of the first transistor 411 may be connected to a ground terminal 422. The source terminal of the first transistor 411 may be connected to the battery sensing end 423 and the source terminal of the second transistor 412. The first transistor 411 may be connected to the source terminal of the second transistor 412 via the source terminal and may perform an operation of accurately determining an input state of the second transistor 412. The drain terminal of the second transistor 412 may be connected to the device sensing end 424. The second transistor 412 may perform an operation of connecting or disconnecting a path between the device sensing end 424 and the battery sensing end 423, which may vary depending on, for example, a voltage of the sensed battery.

In an embodiment, when the sensed battery voltage is greater than or equal to a threshold value, the second transistor 412 may perform an operation of, for example, connecting a path between the device sensing end 424 and the battery sensing end 423. In an embodiment, for example, when the sensed battery voltage is in a predefined normal state, a protection circuit may be turned on and the operating power 421 that operates the switch circuit may operate as a constant power source, thereby turning on the second transistor 412 and connecting a sensing line between the device sensing end 424 and the battery sensing end 423.

In an embodiment, when the sensed battery voltage is less than the threshold value, the second transistor 412 may perform an operation of, for example, disconnecting the path between the device sensing end 424 and the battery sensing end 423. In an embodiment, for example, when the sensed battery voltage is less than a minimum voltage (e.g., 2.5 V), the protection circuit may cut off the battery voltage output, causing the operating power to become Low, and the second transistor 412 may be turned off, thereby disconnecting the sensing line between the device sensing end 424 and the battery sensing end 423.

In an embodiment, when the sensed battery voltage is less than a threshold value and the battery is being charged, the second transistor 412 may perform an operation of, for example, connecting the path between the device sensing end 424 and the battery sensing end 423. In an embodiment, for example, when the sensed battery voltage is less than a minimum voltage (e.g., 2.5 V) and a charger for charging the electronic device is inserted and the battery is being charged, the operating power may be turned on, but the protection circuit may not be turned on, so that an electronic potential difference may exist between the ground terminal of the electronic device and the ground terminal of the battery sensing end 423 due to the battery cell voltage (e.g., less than 2.5 V) and a conduction voltage (e.g., 0.4 V to 0.5 V) of a diode of the power management module. The battery low voltage protection circuit may require that the first transistor 411 is always turned on when in an off state and that a voltage at the gate terminal of the second transistor 412 is maintained. In an embodiment, a voltage applied to the gate terminal of the second transistor 412 may be determined based on a charging voltage of the battery 189, a diode voltage of the power management module, the first resistance 401, and the second resistance 402. In an embodiment, the voltage applied to the gate terminal of the second transistor 412 may be expressed by Equation 1 below.

[Equation 1]

$$V_{GS2} = (VPH_{pwr} + V_d) \times \frac{R_1}{R_1 + R_2}$$

Here, $V_{GS2}$ denotes the voltage applied to the gate terminal of the second transistor 412, $VPH_{pwr}$ denotes the operating power voltage of the switch circuit, $V_d$ denotes the diode voltage of the power management module, and $R_1$ and $R_2$ denote the resistance values of the first resistance 401 and the second resistance 402, respectively. In an embodiment, when the voltage described above is applied to the gate terminal of the second transistor 412, the second transistor 412 may be turned on and the sensing line between the device sensing end 424 and the battery sensing end 423 may be connected. In this scheme of charging after sensing the battery voltage, leakage current may be reduced by controlling the connection and disconnection of the sensing line via the switch circuit 310-2.

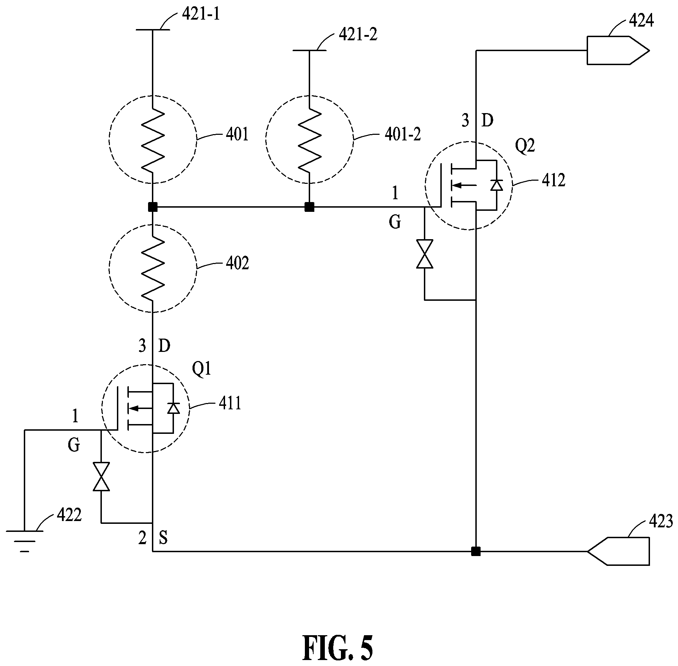

FIG. 5 is a diagram illustrating an operating power of a switch circuit for reducing leakage current according to an embodiment.

Referring to FIG. 5, the operating power of the switch circuit may include a first operating power 421-1 and a second operating power 421-2. Accordingly, the switch circuit may further include a 1-1 resistance 401 connected to the first operating power 421-1 and a 1-2 resistance 401-2 connected to the second operating power 421-2, in addition to a first resistance connected to an existing operating power. This may indicate that the implementation of the switch circuit according to an embodiment is possible without any additional restrictions on the use of the operating power of the switch circuit in any situation where, for example, a low dropout power may be used when a charging voltage is applied. However, embodiments according to the present disclosure are not limited to the particular cases mentioned in the detailed description and drawings of the invention.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic device is not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B," "at least one of A and B," "at least one of A or B," "A, B or C," "at least one of A, B and C," and "at least one of A, B, or C," may include any one of the items listed together in the corresponding one of the phrases, or all possible combinations thereof. Terms such as "1st" and "2nd," or "first" and "second" may be used to simply distinguish a corresponding component from other components, and do not limit the components in other aspects (e.g., importance or order). In addition, as used herein, the terms "couple," "coupling," "coupled," "connect," "connecting," or "connected" may refer to a connection or connection between any two or more elements known in the art or to be developed in the future, including both cases where one or more additional elements are interposed between these two or more elements and cases where no additional elements are interposed between these two or more elements. Conversely, terms such as "directly coupled" and "directly connected" may imply that there are no additional elements between these two or more elements.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Embodiments as set forth herein may be implemented as software including one or more instructions that are stored in a storage medium that is readable by a machine (e.g., the electronic device 100). For example, the machine (e.g., the electronic device 100) may invoke at least one of the one or more instructions stored in the storage medium, and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least portion of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components or operations may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to embodiments, operations performed by the module, the program, or another component may be carried out sequentially, in parallel, repeatedly, or heuristically, or one or more of the operations may be executed in a different order or omitted, or one or more other operations may be added.

Although the embodiments have been described with reference to the limited drawings, one of ordinary skill in the art may apply various technical modifications and variations based thereon. For example, suitable results may be achieved if the described techniques are performed in a different order, and/or if components in a described system, structure, device, or circuit are combined in a different manner, and/or replaced or supplemented by other components or their equivalents.

Therefore, other implementations, other embodiments, and equivalents to the claims are also within the scope of the following claims.

## Claims

1. A switch circuit (310; 310-1), comprising:

   a first resistance (401);
   a first transistor (411); and
   a second transistor (412),
   wherein a first end of the first resistance (401) is connected to an operating power (421) for operating the switch circuit,
   a second end of the first resistance (401) is connected to a drain terminal of the first transistor (411) and a gate terminal of the second transistor (412),
   a gate terminal of the first transistor (411) is connected to a ground terminal (422),
   a source terminal of the first transistor (411) is connected to a battery sensing end (423) of a battery (189) and a source terminal of the second transistor (412), and
   a drain terminal of the second transistor (412) is connected to a device sensing end (424).

2. The switch circuit (310; 310-1) of claim 1, wherein the second transistor (412) is configured to perform an operation of maintaining a voltage of the gate terminal of the second transistor 412 in a predefined range through the first resistance 401.

3. The switch circuit (310; 310-1) of claims 1 or 2, wherein the second transistor (412) is configured to perform an operation of connecting or disconnecting a path between the device sensing end (424) of the battery (189) and the battery sensing end (423) of the battery (189).

4. The switch circuit (310; 310-1) of any one of claims 1 to 3, wherein the second transistor (412) is configured to perform an operation of connecting the path between the device sensing end (424) and the battery sensing end (423), in response to the power of the battery (189) being turned on.

5. The switch circuit (310; 310-1) of any one of claims 1 to 4, wherein the second transistor (412) is configured to perform an operation of disconnecting the path between the device sensing end (424) and the battery sensing end (423), in response to the power of the battery (189) being turned off.

6. The switch circuit (310; 310-1) of any one of claims 1 to 5, wherein the second transistor (412) is configured to perform an operation of connecting a path between the device sensing end (424) and the battery sensing end (423), in response to the battery (189) being charged.

7. The switch circuit (310; 310-2) of any one of claims 1 to 6, further comprising a second resistance (402),

   wherein a first end of the second resistance (402) is connected to the second end of the first resistance (401), and
   a second end of the second resistance (402) is connected to the drain terminal of the first transistor (411).

8. The switch circuit (310; 310-2) of any one of claims 1 to 7, wherein the second transistor (412) is configured to perform the operation of maintaining a voltage of the gate terminal of the second transistor 412 in a predefined range through the first resistance 401 and second resistance (402).

9. The switch circuit (310; 310-2) of any one of claims 1 to 8, wherein the second transistor (412) is configured to perform the operation of connecting or disconnecting a path between the device sensing end (424) of the battery (189) and the battery sensing end (423) of the battery (189).

10. The switch circuit (310; 310-2) of any one of claims 1 to 9, wherein the

    second transistor (412) is configured to perform the operation of connecting the path between the device sensing end (424) and the battery sensing end (423), in response to a voltage of the battery (189) being greater than a threshold value, and
    perform the operation of disconnecting the path between the device sensing end (424) and the battery sensing end (423), in response to a voltage of the battery (189) being less than a threshold value.

11. The switch circuit (310; 310-2) of any one of claims 1 to 10, wherein the second transistor (412) is configured to perform the operation of connecting the path between the device sensing end (424) and the battery sensing end (423), in response to the battery (189) being charged, and a voltage of the battery (189) being less than a threshold value.

12. The switch circuit (310; 310-2) of any one of claims 1 to 11, wherein the voltage applied to the gate terminal of the second transistor (412) is determined based on a charging voltage of the battery (189), a diode voltage of a power management module 188, the first resistance (401), and the second resistance (402).

13. A switch circuit (310; 310-1; 310-2), comprising:

    a first resistance (401);
    a second resistance (402);
    a first transistor (411); and
    a second transistor (412),
    wherein a first end of the first resistance (401) is connected to an operating power (421) for operating the switch circuit,
    a second end of the first resistance (401) is connected to a first end of the second resistance (402) and a gate terminal of the second transistor (412), a second end of the second resistance (402) is connected to a drain terminal of the first transistor (411),
    a gate terminal of the first transistor (411) is connected to a ground terminal (422),
    a source terminal of the first transistor (411) is connected to a battery sensing end (423) and a source terminal of the second transistor (412), and
    a drain terminal of the second transistor (412) is connected to a device sensing end (424).

14. The switch circuit (310; 310-1; 310-2) of claim 13, wherein the second transistor (412) is configured to perform an operation of maintaining a voltage of the gate terminal of the second transistor 412 in a predefined range through the first resistance 401 and the second resistance (402).

15. An electronic device (100), comprising:

    a battery (189) including a battery cell (202) and a protection circuit (201) configured to protect the battery cell (202) from over-discharge; and
    a power management module (188) including a voltage sensing unit (203) configured to sense a voltage of the battery (189) by being directly connected to the battery cell (202) without going through the protection circuit (201) and a switch circuit (310; 310-1; 310-2) configured to block a path between the battery (189) and the voltage sensing unit (203) in response to the protection circuit (201) being deactivated.

FIG. 1

EP 4 589 847 A1

**FIG. 2**

Power management module
**188**

Battery
**189**

203

VOUT

220

System Load

Battery voltage
sensing unit

210-1

BATP
(Cell GND Sense)

BATN

R1

R2

500Ω

Cell

202

Cell GND

500Ω

Q2

Q1

PCM

201

Device GND

310

Battery GND

**FIG. 3**

FIG. 4A

FIG. 4B

**FIG. 5**

**EP 4 589 847 A1**

## INTERNATIONAL SEARCH REPORT

| International application No. |
|---|
| **PCT/KR2023/021962** |

| A. | CLASSIFICATION OF SUBJECT MATTER |
|---|---|

**H03K 17/06**(2006.01)i; **H03K 17/687**(2006.01)i; **H02H 7/18**(2006.01)i

According to International Patent Classification (IPC) or to both national classification and IPC

| B. | FIELDS SEARCHED |
|---|---|

Minimum documentation searched (classification system followed by classification symbols)

H03K 17/06(2006.01); B60L 58/12(2019.01); B60L 58/22(2019.01); G01R 31/3842(2019.01); G01R 31/389(2019.01); G05F 3/26(2006.01); H03K 17/081(2006.01); H03K 17/687(2006.01); H03K 3/0231(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 저항(resistor), 트랜지스터(transistor), 배터리(battery), 센싱(sensing), 스위치(switch), 보호 회로(protection circuit)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | KR 10-2022-0028714 A (LG ENERGY SOLUTION, LTD.) 08 March 2022 (2022-03-08) See paragraphs [0024]-[0041] and figures 2-3. | 15 |
| A | | 1-3,13-14 |
| A | KR 10-2020-0005861 A (SAMSUNG ELECTRO-MECHANICS CO., LTD.) 17 January 2020 (2020-01-17) See paragraphs [0032]-[0053] and figures 1-2. | 1-3,13-15 |
| A | KR 10-2021-0007698 A (SAMSUNG ELECTRONICS CO., LTD.) 20 January 2021 (2021-01-20) See paragraphs [0042]-[0053] and figure 3a. | 1-3,13-15 |
| A | KR 10-2021-0039189 A (HYUNDAI AUTRON CO., LTD.) 09 April 2021 (2021-04-09) See paragraphs [0031]-[0052] and figure 2. | 1-3,13-15 |

✓ Further documents are listed in the continuation of Box C.    ✓ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **02 April 2024** | **03 April 2024** |

| Name and mailing address of the ISA/KR | Authorized officer |
|---|---|
| **Korean Intellectual Property Office** **Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2023/021962**

| C. | DOCUMENTS CONSIDERED TO BE RELEVANT | |
|---|---|---|
| Category* | Citation of document, with indication, where appropriate, of the relevant passages | Relevant to claim No. |
| A | JP 2018-088037 A (SANKEN ELECTRIC CO., LTD.) 07 June 2018 (2018-06-07)<br>See paragraphs [0024]-[0038] and figure 1. | 1-3,13-15 |

Form PCT/ISA/210 (second sheet) (July 2022)

**INTERNATIONAL SEARCH REPORT**

| International application No. |
| --- |
| **PCT/KR2023/021962** |

| **Box No. II** | **Observations where certain claims were found unsearchable (Continuation of item 2 of first sheet)** |
| --- | --- |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☑ Claims Nos.: **4-12**
because they are dependent claims and are not drafted in accordance with the second and third sentences of Rule 6.4(a).

Form PCT/ISA/210 (continuation of first sheet) (July 2022)

### INTERNATIONAL SEARCH REPORT
**Information on patent family members**

International application No.

**PCT/KR2023/021962**

| Patent document cited in search report | | | Publication date (day/month/year) | Patent family member(s) | | | Publication date (day/month/year) |
|---|---|---|---|---|---|---|---|
| KR | 10-2022-0028714 | A | 08 March 2022 | CN | 115461956 | A | 09 December 2022 |
| | | | | EP | 4148948 | A1 | 15 March 2023 |
| | | | | JP | 2023-525238 | A | 15 June 2023 |
| | | | | US | 2023-0208162 | A1 | 29 June 2023 |
| | | | | WO | 2022-045687 | A1 | 03 March 2022 |
| KR | 10-2020-0005861 | A | 17 January 2020 | CN | 110708050 | A | 17 January 2020 |
| | | | | CN | 110708050 | B | 04 August 2023 |
| | | | | KR | 10-2583788 | B1 | 26 September 2023 |
| | | | | US | 11177801 | B2 | 16 November 2021 |
| | | | | US | 2020-0014380 | A1 | 09 January 2020 |
| KR | 10-2021-0007698 | A | 20 January 2021 | WO | 2021-010622 | A1 | 21 January 2021 |
| KR | 10-2021-0039189 | A | 09 April 2021 | KR | 10-2317074 | B1 | 25 October 2021 |
| JP | 2018-088037 | A | 07 June 2018 | US | 2018-0152138 | A1 | 31 May 2018 |

Form PCT/ISA/210 (patent family annex) (July 2022)